# FASCICULE DE BREVET EUROPEEN

(11) **EP 1 680 782 B1**
(45) Date de publication et mention de la délivrance du brevet: **07.05.2008**
(21) Numéro de dépôt: 04805312.8
(22) Date de dépôt: 26.10.2004
(51) Int. Cl.: G11B 9/00, G11B 11/00, G01B 7/34, G12B 21/02

(54) **DISPOSITIF D' ENREGISTREMENT DE DONNEES A MICRO-POINTES CONDUCTRICES ET PROCEDE DE FABRICATION D' UN TEL DISPOSITIF**
DATENAUFZEICHNUNGSEINRICHTUNG MIT LEITFÄHIGEN MIKROTIPS UND HERSTELLUNGSVERFAHREN DAFÜR
DATA-RECORDING DEVICE COMPRISING CONDUCTIVE MICROTIPS AND PRODUCTION METHOD THEREOF

(30) Priorité: 06.11.2003 FR 0313042
(43) Date de publication de la demande: 19.07.2006
(73) Titulaire: COMMISSARIAT A L'ENERGIE ATOMIQUE, 75752 Paris (FR)
(72) Inventeur: GIDON, Serge, F-38140 La Murette (FR); SAMSON, Yves, 38000 Grenoble (FR)
(74) Mandataire: Hecké, Gérard
(86) Numéro de dépôt international: PCT/FR2004/002755
(87) Numéro de publication internationale: WO 2005/048255

(56) Documents cités:
- EP-A- 1 054 249
- EP-A- 1 274 092
- WO-A-00/19494
- WO-A-98/05920
- WO-A-03/060923
- US-A1- 2002 117 611
- US-A1- 2002 117 951
- US-A1- 2003 042 922
- US-A1- 2003 052 585

## Description

### Domaine technique de l'invention

L'invention concerne un dispositif d'enregistrement de données comportant au moins une micro-pointe électriquement conductrice ayant une extrémité destinée à être amenée en contact électrique avec un support d'enregistrement, la micro-pointe comportant une âme longitudinale conductrice ayant une section sensiblement constante.

### État de la technique

Les techniques d'écriture et de lecture de points mémoires par micro-pointes permettent d'obtenir de très grandes densités de stockage de données.

Plusieurs techniques reposent sur l'usage de micro-pointes électriquement conductrices, afin, par exemple, de réaliser des cartographies locales de résistivité électrique d'un support d'enregistrement. Pour écrire ou lire des données, la micro-pointe est amenée au contact du support d'enregistrement ou à proximité de celui-ci. L'abrasion progressive de l'extrémité des micro-pointes peut entraîner une dégradation des performances du dispositif d'enregistrement et, éventuellement, la destruction de la micro-pointe.

De nombreux types de supports d'enregistrement sont proposés pour le stockage de données écrites et/ou lues à partir de l'injection de courants par l'intermédiaire de la micro-pointe. La surface de contact électrique entre la micro-pointe et le support d'enregistrement est un des paramètres principaux contrôlant la résolution en lecture et la densité obtenue en écriture. Un faible rayon de courbure est généralement recherché pour le sommet de la micro-pointe. L'abrasion progressive peut entraîner l'élargissement de la surface de contact électrique entre la micro-pointe et le support d'enregistrement et, ainsi, altérer le rayon de courbure du sommet de la micro-pointe et modifier les propriétés électriques de la micro-pointe en perdant la résolution recherchée.

La plupart des micro-pointes conductrices est basée sur la technologie du silicium qui permet d'obtenir un sommet (apex) de micro-pointe de très faible rayon de courbure. Une technique, par exemple, consiste à réaliser d'abord une couche de silicium très fortement dopée, donc conductrice. Ensuite la couche est gravée de manière anisotrope, afin de tailler la micro-pointe. Une autre technique consiste à fabriquer d'abord une micro-pointe en silicium non dopé et de recouvrir la micro-pointe d'une couche de matériaux conducteurs comme des nitrures ou des carbures qui sont, par ailleurs, des matériaux particulièrement durs. Certaines techniques utilisent la dureté du diamant pour protéger la micro-pointe. Ainsi, la micro-pointe est recouverte d'une couche de diamant, ce qui nécessite des procédés de fabrication complexes et présentant des coûts élevés.

Ces dispositifs comportent des micro-pointes de forme pyramidale, conique ou tronconique. Ces micro-pointes sont relativement solides, mais leurs propriétés électriques évoluent en fonction du processus d'usure.

Certains dispositifs comportent des micro-pointes de section constante, ce qui permet d'obtenir des propriétés électriques indépendantes du processus d'usure. Cependant, de telles micro-pointes sont très fragiles.

Par ailleurs, dans le cas de réseaux de micro-pointes, pour tenir compte de la dispersion statistique des longueurs des micro-pointes, chaque micro-pointe est supportée par un élément souple, par exemple par un cantilever, ce qui permet d'amener simultanément l'ensemble des micro-pointes au contact du support d'enregistrement. Cependant la fabrication des cantilevers rajoute des étapes complexes au procédé de fabrication des dispositifs.

Le document WO03/060923 décrit un dispositif d'enregistrement de données comportant un réseau de micro-pointes à cantilever. Chaque micro-pointe comporte un nanotube faisant saillie sur le matériau de la micropointe dans lequel il est inséré. Le matériau du cantilever peut comporter un matériau polymère ou un diélectrique, des métaux ou du polysilicium. La pointe et le cantilever peuvent être délimités par lithographie, gravure sèche ou gravure humide. Le nanotube a une section constante et la section du matériau de la micropointe diminue en direction de l'extrémité de la micro-pointe.

### Objet de l'invention

L'invention a pour but de remédier à ces inconvénients et, en particulier, de réaliser un dispositif comportant au moins une micro-pointe solide, tout en présentant des propriétés électriques indépendantes du processus d'usure.

Selon l'invention, ce but est atteint par les revendications annexées et, en particulier, par le fait que la micro-pointe est entourée par une gaine en matériau non-conducteur, de manière à ce que les extrémités libres de l'âme et de la gaine soient au même niveau à l'extrémité de la micro-pointe.

L'invention a également pour but un procédé de fabrication d'un dispositif d'enregistrement de données selon l'invention, comportant une étape d'abrasion, de manière à ce que les extrémités libres de l'âme et de la gaine soient au même niveau à l'extrémité de la micro-pointe.

### Description sommaire des dessins

D'autres avantages et caractéristiques ressortiront plus clairement de la description qui va suivre de modes particuliers de réalisation de l'invention donnés à titre d'exemples non limitatifs et représentés aux dessins annexés, dans lesquels :
Les figures 1 et 2 représentent en coupe un mode de réalisation particulier d'un dispositif d'enregistrement de données selon l'invention, comportant respectivement une micro-pointe non-usée et une micro-pointe usée.
Les figures 3 et 4 représentent, respectivement en coupe selon l'axe A-A et selon l'axe B-B, l'extrémité de la micro-pointe du dispositif des figures 1 et 2.
La figure 5 représente un mode de réalisation particulier d'un dispositif d'enregistrement de données selon l'invention comportant un réseau de micro-pointes.
La figure 6 illustre un mode de réalisation particulier d'un dispositif selon l'invention intégré dans un boîtier comportant également le support d'enregistrement.
Les figures 7 à 11 représentent un mode de réalisation particulier d'un procédé de réalisation du dispositif d'enregistrement de données selon l'invention.
Les figures 12 à 16 représentent un autre mode de réalisation particulier d'un procédé de réalisation du dispositif d'enregistrement de données selon l'invention.

### Description de modes particuliers de réalisation

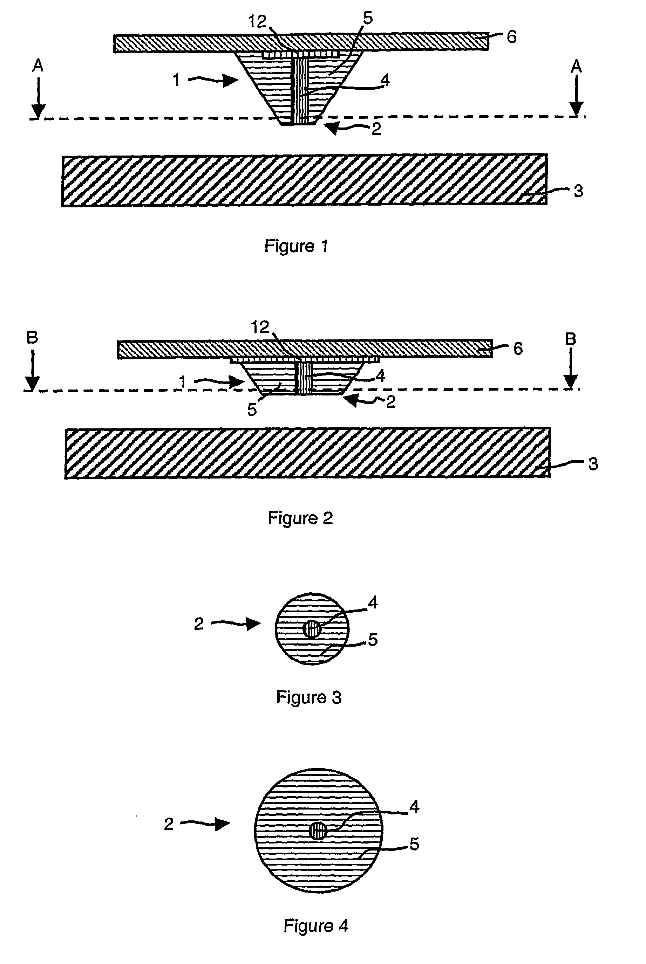

Sur la figure 1, un dispositif d'enregistrement de données comporte une micro-pointe 1 tronconique ayant une extrémité 2 destinée à être amenée en contact électrique avec un support d'enregistrement 3. La micro-pointe 1 comporte une âme 4 longitudinale conductrice ayant une section sensiblement constante et entourée par une gaine 5 en matériau non-conducteur. La gaine 5 a, par exemple, une section qui diminue en direction de l'extrémité 2 de la micro-pointe 1. Par exemple, la gaine 5 peut avoir une partie tronconique ou pyramidale. Dans le mode de réalisation particulier représenté à la figure 1, la gaine 5 a un plateau, parallèle au support d'enregistrement 3, à l'extrémité 2 de la micro-pointe 1, l'âme 4 a une section circulaire et est solidaire d'un substrat 6 par l'intermédiaire d'une piste conductrice 12. La figure 1 représente le dispositif non-usé.

Lorsque plusieurs micro-pointes 1 sont disposées, par l'intermédiaire de pistes conductrices 12, sur un même substrat 6, celui-ci peut être choisi isolant, ce qui permet d'isoler électriquement les micro-pointes 1 les unes des autres. Dans le cas d'une seule micro-pointe 1, le substrat 6 peut être choisi conducteur et une piste conductrice 12 n'est pas nécessaire.

Sur la figure 2, le dispositif d'enregistrement de données de la figure 1 est représenté après usure. Ainsi, une partie de la micro-pointe 1 a été enlevée par abrasion progressive de l'extrémité 2.

Les figures 3 et 4 illustrent respectivement les extrémités 2 de la micro-pointe 1 tronconique selon les figures 1 et 2, sans représenter le support d'enregistrement. La gaine 5 de l'extrémité 2 représentée à la figure 4 est usée et présente, ainsi, un diamètre extérieur supérieur à celui de la gaine 5 de l'extrémité 2 non-usée représentée à la figure 3. Le diamètre de l'âme 4 est égal sur les figures 3 et 4.

La section de l'âme 4 conductrice étant sensiblement constante, la surface de contact électrique entre l'extrémité 2 de la micro-pointe 1 et le support d'enregistrement 3 est indépendante du stade du processus d'abrasion. La zone de contact mécanique entre l'extrémité 2 de la micro-pointe 1 et le support d'enregistrement 3 est définie par les dimensions latérales de la gaine 5. La zone de contact mécanique est, ainsi, supérieure à la surface de contact électrique. Ainsi, la force de contact est répartie sur une zone de plus en plus grande lors du processus d'abrasion et, par conséquent, la pression de contact est de plus en plus faible et la vitesse du processus d'abrasion diminue à mesure que l'usure avance, conduisant à ce que les surfaces en présence s'épousent, notamment dans le cas où il y a plusieurs micro-pointes.

La gaine 5 peut être constituée par un matériau isolant, par exemple de la silice, ou par un matériau faiblement conducteur, par exemple par un matériau semiconducteur, de manière à ce que la résistance de la gaine 5 soit sensiblement supérieure à la résistance de l'âme 4. Par exemple, la conductivité du matériau de la gaine 5 peut être dix fois plus faible que la conductivité du matériau de l'âme 4.

Dans un mode de réalisation particulier, l'âme 4 est constituée par un nanotube de carbone. Par exemple, on peut faire croître un nanotube de carbone en utilisant une piste métallique déposée sur un substrat en silicium, la piste métallique comportant typiquement un catalyseur, par exemple un métal de transition. A titre d'exemple, un procédé de croissance de nanotubes de carbone alignés verticalement, utilisant un dépôt chimique en phase vapeur assisté par plasma, est décrit dans le document "Growth process conditions of vertically aligned carbon nanotubes using plasma enhanced chemical vapor deposition" de M. Chhowalla et Al. (J. Appl. Phys., Vol. 90, No. 10, 15 November 2001). Dans ce procédé, la piste métallique est fragmentée par frittage, de manière à former des particules métalliques nanométriques sur le substrat. Pendant le dépôt chimique en phase vapeur, un nanotube de carbone croît sous chaque particule métallique nanométrique.

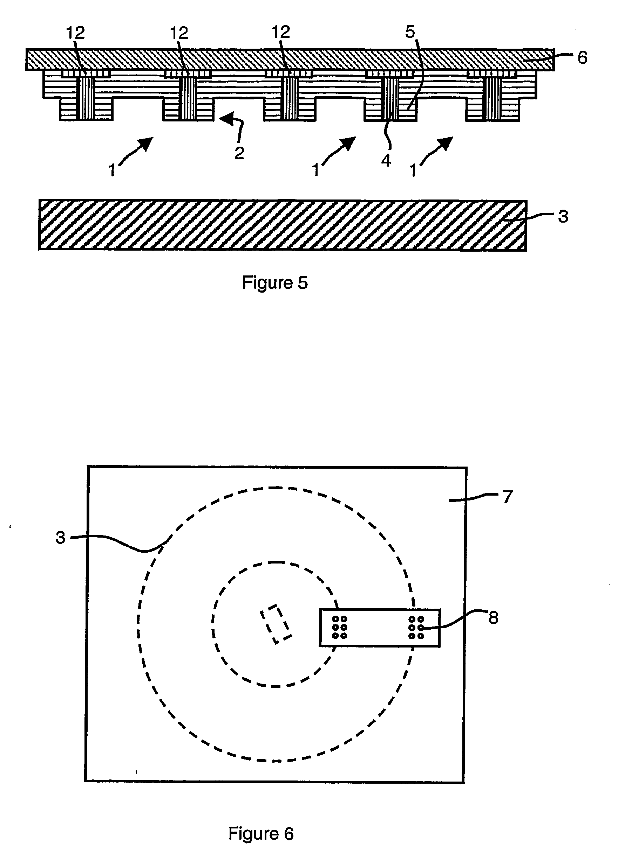

Le dispositif d'enregistrement représenté sur la figure 5 comporte une multitude de micro-pointes 1 disposées selon un réseau unidimensionnel ou bidimensionnel. Leurs extrémités 2 génèrent une surface commune sensiblement plane. Selon le type de procédé de fabrication du dispositif employé, les extrémités 2 peuvent générer une surface plane ou de faible concavité, par exemple une surface sphérique ou cylindrique. Les micro-pointes 1 sont disposées, respectivement, sur les pistes conductrices 12, et électriquement séparées par le substrat 6 dont le matériau a une conductivité sensiblement plus faible, par exemple 10 fois plus faible, que le matériau des pistes conductrices 12.

La figure 6 illustre un dispositif d'enregistrement intégré dans un boîtier 7 étanche aux poussières et comportant également un disque mémoire constituant le support d'enregistrement 3. Le boîtier 7 est destiné à communiquer avec un lecteur de mémoire par l'intermédiaire d'une pluralité de contacts électriques 8 disposés à l'extérieur du boîtier 7. Ainsi, on obtient une mémoire échangeable comportant une tête de lecture constituée par les micro-pointes 1. Le lecteur comporte également des actionneurs servant à assurer le mouvement relatif de la tête de lecture et du support d'enregistrement 3. Par exemple, un moteur peut entraîner le disque mémoire et une unité de translation radiale peut déplacer la tête de lecture selon les lignes de points mémoires choisies sur le disque. L'amplitude du déplacement de l'unité de translation est, par exemple, supérieure ou égale au pas linéique entre deux micro-pointes 1 voisines, par exemple compris entre 10µm et 100µm.

L'espace entre les micro-pointes 1 et le support d'enregistrement 3 peut être rempli par un lubrifiant à faible conductivité, par exemple par du graphite, du silicone ou un liquide, qui assure la conduction électrique entre la micro-pointe 1 et le support d'enregistrement 3. La conductivité électrique du lubrifiant doit être suffisamment faible pour ne pas créer un court-circuit entre des micro-pointes 1 voisines (lubrifiant de type Z-DOL ou graphite ou silicone).

Un procédé de fabrication d'un dispositif d'enregistrement de données selon l'invention comporte, après assemblage des matériaux constituants respectivement l'âme 4 et la gaine 5 d'une micro-pointe 1, une étape d'abrasion, de manière à ce que les extrémités libres de l'âme 4 et de la gaine 5 soient au même niveau à l'extrémité 2 de la micro-pointe 1. De préférence, l'étape d'abrasion est effectuée par planarisation mécano-chimique. Compte tenu de la dispersion statistique des longueurs des âmes avant abrasion, on peut, par exemple, polir l'ensemble des matériaux constituants les âmes 4 et les gaines 5 jusqu'à ce que l'épaisseur de l'ensemble corresponde, par exemple, à la moitié de la longueur moyenne des âmes 4.

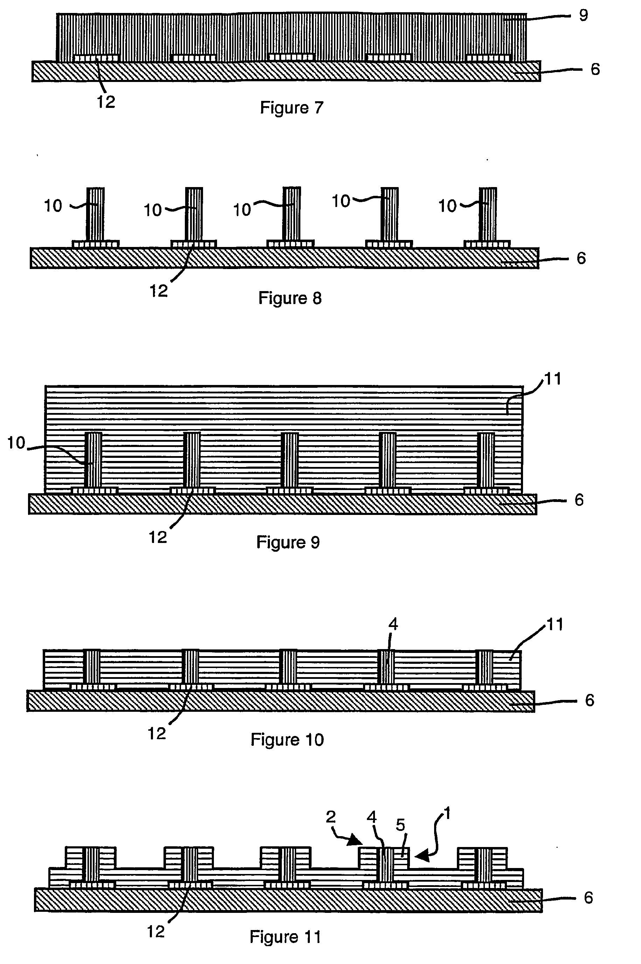

Un procédé de fabrication d'un dispositif d'enregistrement de données selon la figure 5 comporte les étapes représentées aux figures 7 à 11.

La première étape consiste, comme représenté à la figure 7, à déposer une couche 9 de matériau conducteur sur un substrat 6. Le matériau conducteur peut être du silicium polycristallin, du carbone ou un métal et le substrat 6 est, par exemple, en silicium recouvert de silice. Le dépôt de la couche 9 peut être effectué par un procédé classique comme la pulvérisation ou un dépôt chimique en phase vapeur.

Le substrat 6 a été au préalable muni de pistes conductrices 12 par dépôt d'une couche métallique, par exemple en cuivre, gravée par un procédé de photolithographie et de gravure quelconque. Sur ces pistes conductrices 12 sont déposées les âmes 4, dans les étapes suivantes.

La deuxième étape consiste, comme représenté à la figure 8, à graver, à travers un masque, le matériau conducteur de la couche 9, de manière à former des plots 10 destinés à constituer chacun une âme 4 d'une micro-pointe 1.

Puis, dans une troisième étape, illustrée à la figure 9, on dépose, sur le substrat 6 muni des plots 10, une couche 11 du matériau non-conducteur destiné à constituer la gaine 5. Les différentes méthodes de dépôt dépendent du matériau non-conducteur choisi. Ainsi, une couche de carbone du type carbone quasi-diamant ou DLC (« DLC : Diamond like carbon ») peut être déposée par dépôt chimique en phase vapeur à partir de méthane ou de monoxyde de carbone, une couche de Si₃N₄ peut être réalisée par pulvérisation et une couche de SiO₂ peut être obtenue par dépôt sur tournette de silice obtenue par un procédé de type sol gel. L'épaisseur du dépôt de la couche 11 du matériau non-conducteur représenté à la figure 9 est choisie pour que les plots 10 soient complètement immergés dans la couche 11. Cependant, il est également possible de déposer une couche 11 dont l'épaisseur ne dépasse pas la hauteur des plots 10.

Ensuite, une quatrième étape consiste, comme représenté à la figure 10, à effectuer l'abrasion, comme décrit précédemment, de manière à ce que, en fin d'abrasion, les extrémités libres des plots 10 et des gaines 5 soient au même niveau à l'extrémité 2 de chaque micro-pointe 1.

Dans une cinquième étape, représentée à la figure 11, le matériau non-conducteur de la couche 11 est gravé, de manière à délimiter la gaine 5 latéralement. Ainsi, la zone de contact mécanique entre l'extrémité 2 de la micro-pointe 1 et le support d'enregistrement 3 peut être diminuée et, ainsi, les forces de friction sont réduites. La couche 11 est gravée entre les âmes 4, dans un intervalle de largeur prédéterminée inférieure à l'écart entre deux âmes 4, sur une profondeur prédéterminée qui ne correspond pas nécessairement à l'épaisseur de la couche 11. Ainsi, la gaine 5 de chaque micro-pointe représentée à la figure 11 obtient une section constante à l'extrémité 2 de la micro-pointe, tandis qu'en proximité du substrat 6, la couche 11 couvre l'espace entier entre les plots. La gravure peut être faite par voie chimique ou par bombardement ionique. L'étape de gravure comporte également le masquage lithographique.

Une micro-pointe unique ou un réseau quelconque de micro-pointes, bidimensionnel ou unidimensionnel, peut être réalisé par un procédé analogue au procédé décrit précédemment.

Tandis que dans le procédé représenté aux figures 7 à 11, les âmes 4 sont réalisées avant la gaine 5, dans un autre mode de réalisation d'un procédé de réalisation, la gaine 5 est réalisée avant les âmes 4. Dans tous les cas on peut mettre en oeuvre soit une lithographie soit un processus d'auto-organisation pour délimiter les âmes 4.

Dans le cas où l'âme 4 est réalisée en premier, par exemple par gravure d'un matériau conducteur (figure 8), ou par croissance locale dans le cas de nanotubes en carbone, il peut être nécessaire de réduire le diamètre de l'âme 4 ainsi obtenu, ce qui peut être fait par une étape d'attaque réactive isotrope. Le dépôt de la gaine 5 (figure 9) peut alors être réalisé par un procédé physique en phase vapeur, cas d'un graphite amorphe par exemple, par un procédé chimique en phase vapeur, cas de la silice, des nitrures ou du carbone quasi-diamant, ou par un procédé de type sol-gel, par exemple par trempage.

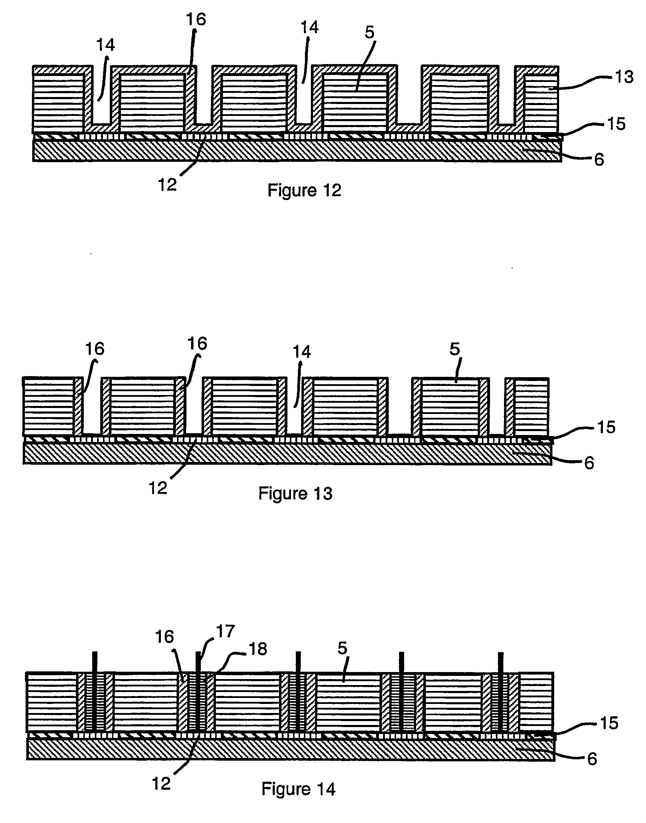

Les figures 12 à 16 illustrent un procédé de fabrication, dans lequel la gaine 5 est réalisée avant l'âme 4. Les micro-pointes 1 sont réalisées sur un substrat 6 comportant, par exemple, des couches conductrices 12 et une couche de planarisation 15. Une couche 13 d'un matériau destiné à constituer la gaine 5 est déposée par un procédé quelconque, par exemple par un des procédés mentionnés précédemment. Ensuite, comme représenté à la figure 12, des orifices 14 traversants sont gravés dans la couche 13. Afin de diminuer la taille des orifices 14 ainsi obtenus, un matériau 16 est déposé sur la face avant des gaines 5, sur les parois des orifices 14 et sur le fond de chaque orifice 14. Une gravure anisotrope permet ensuite d'enlever le matériau 16 du fond de chaque orifice 14 et de la face avant des gaines 5 (figure 13).

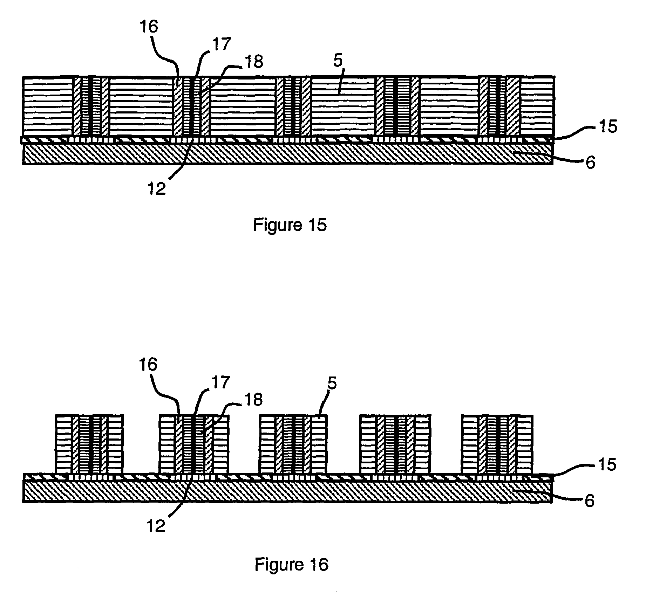

L'âme est ensuite réalisée par tout processus envisageable de dépôt d'un matériau conducteur comme le tungstène ou par dépôt d'un catalyseur, comme le nickel pour la croissance de nanotubes de carbone 17 à partir du fond de chaque orifice 14, comme représenté à la figure 14. Dans ce dernier cas, l'orifice est comblé par un matériau supplémentaire 18, par exemple par un dépôt électrolytique d'un matériau conducteur, par exemple du tungstène, du cuivre ou du nickel. Ensuite, comme représenté à la figure 15, une abrasion de la face avant de l'empilement ainsi obtenu permet d'obtenir des longueurs uniformes des âmes 4 constituées par les nanotubes de carbone 17. Ensuite, la gaine 5 est gravée sur une profondeur prédéterminée, par exemple sur toute sa profondeur comme représenté à la figure 16 ou sur une profondeur intermédiaire comme représenté à la figure 11.

Le procédé selon l'invention permet d'obtenir un réseau de micro-pointes 1 dont les extrémités 2 forment une surface commune sensiblement plane, ce qui permet d'amener simultanément l'ensemble des micro-pointes 1 au contact du support d'enregistrement 3, sans avoir besoin d'éléments souples comme des cantilevers pour compenser des différences des longueurs des micro-pointes 2.

Le réseau de micro-pointes peut être utilisé en matrice bidimensionnelle par similitude avec la solution millipede^{®} de la société IBM ou en barrette pour usage avec une mémoire en forme de disque rotatif. Dans le cas d'un disque rotatif, le support d'enregistrement 3 peut, par exemple, être en plastique.

L'invention n'est pas limitée aux modes de réalisation représentés. En particulier, la gaine 5 peut avoir une paroi extérieure de forme quelconque. Par exemple, la paroi peut avoir une section cylindrique ou carrée. La micro-pointe 1 selon l'invention peut également être disposée sur un cantilever, obtenu, par exemple, par gravure après la réalisation de la micro-pointe.

## Revendications

1. Dispositif d'enregistrement de données comportant au moins une micro-pointe (1) électriquement conductrice ayant une extrémité (2) destinée à être amenée en contact électrique avec un support d'enregistrement (3), la micro-pointe (1) comportant une âme (4) longitudinale conductrice ayant une section sensiblement constante,
**caractérisé en ce que** la micro-pointe (1) est entourée par une gaine (5) en matériau non-conducteur, de manière à ce que les extrémités libres de l'âme (4) et de la gaine (5) soient au même niveau à l'extrémité (2) de la micro-pointe.

2. Dispositif selon la revendication 1, **caractérisé en ce que** la gaine (5) est en matériau isolant.

3. Dispositif selon la revendication 1, **caractérisé en ce que** la gaine (5) est en matériau faiblement conducteur.

4. Dispositif selon l'une quelconque des revendications 1 à 3, **caractérisé en ce que** la gaine (5) a une section qui diminue en direction de l'extrémité (2) de la micro-pointe (1).

5. Dispositif selon la revendication 4, **caractérisé en ce que** la gaine (5) comporte une partie tronconique.

6. Dispositif selon l'une quelconque des revendications 1 à 5, **caractérisé en ce que** l'âme (4) est constituée par un nanotube de carbone (17).

7. Dispositif selon l'une quelconque des revendications 1 à 6, **caractérisé en ce qu'**il comporte une multitude de micro-pointes (1) disposées selon un réseau, leurs extrémités (2) générant une surface commune sensiblement plane.

8. Dispositif selon la revendication 7, **caractérisé en ce qu'**il est intégré dans un boîtier (7) étanche aux poussières comportant également le support d'enregistrement (3) et destiné à communiquer avec un lecteur de mémoire par l'intermédiaire d'une pluralité de contacts électriques (8) disposés à l'extérieur du boîtier (7).

9. Dispositif selon l'une quelconque des revendications 1 à 8, **caractérisé en ce que** l'âme (4) est solidaire d'un substrat (6) par l'intermédiaire d'une piste conductrice (12).

10. Dispositif selon la revendication 9, **caractérisé en ce que** le substrat (6) a une conductivité sensiblement plus faible que la piste conductrice (12).

11. Procédé de fabrication d'un dispositif d'enregistrement de données selon l'une quelconque des revendications 1 à 10,
**caractérisé en ce qu'**il comporte une étape d'abrasion, de manière à ce que les extrémités libres de l'âme (4) et de la gaine (5) soient au même niveau à l'extrémité (2) de la micro-pointe (1).

12. Procédé de fabrication selon la revendication 11, **caractérisé en ce que** l'étape d'abrasion est effectuée par planarisation mécano-chimique.

13. Procédé de fabrication selon l'une des revendications 11 et 12, **caractérisé en ce qu'**il comporte, avant l'étape d'abrasion,
- le dépôt d'une couche (9) de matériau conducteur sur un substrat (6),
- la gravure, à travers un masque, du matériau conducteur, de manière à former au moins un plot (10) destiné à constituer l'âme (4) d'une micro-pointe (1),
- le dépôt, au moins sur le substrat (6), d'une couche (11) du matériau non-conducteur destiné à constituer la gaine (5),
et, après l'étape d'abrasion, la gravure du matériau non-conducteur, de manière à délimiter la gaine (5) latéralement.

14. Procédé de fabrication selon l'une des revendications 11 et 12, **caractérisé en ce qu'**il comporte, avant l'étape d'abrasion,
- le dépôt d'une couche (13) de matériau non-conducteur destiné à constituer la gaine (5) sur un substrat (6),
- la gravure d'orifices (14) traversants dans la couche (13),
- le dépôt d'un matériau (16) au moins sur les parois et le fond de chaque orifice (14),
- l'enlèvement du matériau (16) du fond de chaque orifice (14) par gravure anisotrope,
- le dépôt du matériau destiné à constituer l'âme (4) dans les orifices (14),
et, après l'étape d'abrasion, la gravure de la couche (13), de manière à délimiter la gaine (5) latéralement.

## Claims

1. Data recording device comprising at least one electrically conducting microtip (1) having an end (2) designed to be brought into electric contact with a recording medium (3), the microtip (1) comprising a longitudinal conducting core (4) having a substantially constant cross-section,
**characterized in that** the microtip (1) is surrounded by a sheath (5) made of non-conducting material, so that the free ends of the core (4) and of the sheath (5) are at the same level at the end (2) of the microtip.

2. Device according to claim 1, **characterized in that** the sheath (5) is made of insulating material.

3. Device according to claim 1, **characterized in that** the sheath (5) is made of material having a low conductivity.

4. Device according to any one of the claims 1 to 3, **characterized in that** the sheath (5) has a cross-section that decreases in the direction of the end (2) of the microtip (1).

5. Device according to claim 4, **characterized in that** the sheath (5) comprises a truncated-cone-shaped part.

6. Device according to any one of the claims 1 to 5, **characterized in that** the core (4) is formed by a carbon nanotube (17).

7. Device according to any one of the claims 1 to 6, **characterized in that** it comprises a multitude of microtips (1) arranged as a lattice, the ends (2) thereof generating a substantially flat common surface.

8. Device according to claim 7, **characterized in that** it is integrated in a dustproof chip (7) also containing the recording medium (3) and designed to communicate with a memory reader by means of a plurality of electric contacts (8) arranged outside the chip (7).

9. Device according to any one of the claims 1 to 8, **characterized in that** the core (4) is securely affixed to a substrate (6) by means of a conducting track (12).

10. Device according to claim 9, **characterized in that** the substrate (6) has a substantially lower conductivity than the conducting track (12).

11. Method for production of a data recording device according to any one of the claims 1 to 10,
**characterized in that** it comprises an abrasion step so that the free ends of the core (4) and of the sheath (5) are at the same level at the end (2) of the microtip (1).

12. Method for production according to claim 11, **characterized in that** the abrasion step is performed by mechano-chemical planarization.

13. Method for production according to one of the claims 11 and 12, **characterized in that** it comprises, before the abrasion step,
- deposition of a layer (9) of conducting material on a substrate (6),
- etching of the conducting material, through a mask, so as to form at least one pillar (10) designed to form the core (4) of a microtip (1),
- deposition, at least on the substrate (6), of a layer (11) of the non-conducting material designed to constitute the sheath (5),
and, after the abrasion step, etching of the non-conducting material so as to delineate the sheath (5) laterally.

14. Method for production according to one of the claims 11 and 12, **characterized in that** it comprises, before the abrasion step,
- deposition of a layer (13) of non-conducting material designed to constitute the sheath (5) on a substrate (6),
- etching of pass-through holes (14) in the layer (13),
- deposition of a material (16) at least on the walls and the bottom of each hole (14),
- removal of the material (16) from the bottom of each hole (14) by anisotropic etching,
- deposition of the material designed to form the core (4) in the holes (14),
and, after the abrasion step, etching of the layer (13) so as to delineate the sheath (5) laterally.

## Patentansprüche

1. Datenaufzeichnungsvorrichtung, die mindestens eine elektrisch leitende Mikrospitze (1) mit einem Ende (2) umfasst, das in elektrischen Kontakt mit einem Aufzeichnungsmedium (3) gebracht werden soll, wobei die Mikrospitze (1) in Längsrichtung einen leitenden Kern (4) umfasst, der einen im Wesentlichen konstanten Querschnitt aufweist,
**dadurch gekennzeichnet, dass** die Mikrospitze (1) von einer Hülse (5) aus nicht leitendem Material eingeschlossen ist, sodass sich die freien Enden des Kerns (4) und der Hülse (5) am Ende (2) der Mikrospitze in gleicher Höhe befinden.

2. Vorrichtung nach Anspruch 1, **dadurch gekennzeichnet, dass** die Hülse (5) aus isolierendem Material besteht.

3. Vorrichtung nach Anspruch 1, **dadurch gekennzeichnet, dass** die Hülse (5) aus einem geringfügig leitenden Material besteht.

4. Vorrichtung nach einem der Ansprüche 1 bis 3, **dadurch gekennzeichnet, dass** die Hülse (5) einen Querschnitt aufweist, der sich in Richtung auf das Ende (2) der Mikrospitze (1) hin verringert.

5. Vorrichtung nach Anspruch 4, **dadurch gekennzeichnet, dass** die Hülse (5) einen kegelstumpfförmigen Bereich umfasst.

6. Vorrichtung nach einem der Ansprüche 1 bis 5, **dadurch gekennzeichnet, dass** der Kern (4) von einer Kohlenstoff-Nanotube (17) gebildet wird.

7. Vorrichtung nach einem der Ansprüche 1 bis 6, **dadurch gekennzeichnet, dass** sie eine Vielzahl Mikrospitzen (1) umfasst, die netzförmig angeordnet sind, wobei ihre Enden (2) eine im Wesentlichen ebene gemeinsame Fläche bilden.

8. Vorrichtung nach Anspruch 7, **dadurch gekennzeichnet, dass** sie in einem staubdichten Gehäuse (7) untergebracht ist, das auch das Aufzeichnungsmedium (3) einschließt, und dazu bestimmt ist, über eine Mehrzahl elektrischer Kontakte (8), die außerhalb des Gehäuses (7) angeordnet sind, mit einem Speicherlesegerät zu kommunizieren.

9. Vorrichtung nach einem der Ansprüche 1 bis 8, **dadurch gekennzeichnet, dass** der Kern (4) über eine Leiterbahn (12) fest mit einem Substrat (8) verbunden ist.

10. Vorrichtung nach Anspruch 9, **dadurch gekennzeichnet, dass** das Substrat (6) eine im Wesentlichen geringere Konduktivität hat als die Leiterbahn (12).

11. Herstellungsverfahren für eine Datenaufzeichungsvorrichtung nach einem der Ansprüche 1 bis 10, **dadurch gekennzeichnet, dass** es einen Schleifschritt umfasst, der bewirkt, dass sich die freien Enden des Kerns (4) und der Hülse (5) am Ende (2) der Mikrospitze (1) in gleicher Höhe befinden.

12. Herstellungsverfahren nach Anspruch 11, **dadurch gekennzeichnet, dass** der Schleifschritt durch chemisch-mechanische Planarisation erfolgt.

13. Herstellungsverfahren nach einem der Ansprüche 11 und 12, **dadurch gekennzeichnet, dass** es umfasst, vor dem Schleifschritt,
- das Abscheiden einer Schicht (9) aus leitendem Material auf ein Substrat (6),
- das Zurückätzen des leitenden Materials durch eine Maske hindurch, sodass mindestens ein Stift (10) entsteht, der den Kern (4) einer Mikrospitze (1) bildet,
- das Abscheiden mindestens einer Schicht (11) des nicht leitenden Materials, das die Hülse (5) bilden soll, auf zumindest das Substrat (6),
und nach dem Schleifschritt, das Zurückätzen des nicht leitenden Materials, um die Hülse (5) seitlich zu begrenzen.

14. Herstellungsverfahren nach einem der Ansprüche 11 und 12, **dadurch gekennzeichnet, dass** es umfasst, vor dem Schleifschritt,
- das Abscheiden einer Schicht (13) aus nicht leitendem Material, das die Hülse (5) bilden soll, auf einem Substrat (6),
- das Zurückätzen von durchführenden Öffnungen (14) in der Schicht (13),
- das Aubscheiden eines Materials (16) zumindest auf den Wänden und dem Boden jeder Öffnung (14),
- das Entfernen des Materials (16) vom Boden jeder Öffnung (14) durch anisotropes Ätzen,
- das Abscheiden des Materials, das den Kern (4) bilden soll, in den Öffnungen (14),
und nach dem Schleifschritt, das Zurückätzen der Schicht (13), um die Hülse (5) seitlich zu begrenzen.
